# EUROPEAN PATENT APPLICATION

(11) **EP 4 826 403 A1**
(43) Date of publication of application: **21.10.2026**
(21) Application number: 25873745.1
(22) Date of filing: 11.09.2025
(51) Int. Cl.: G01R 31/382, G01R 31/392, G01R 31/396, G01R 31/367, G01R 19/165, H01M 10/48

(54) **BATTERY DIAGNOSIS DEVICE AND METHOD THEREFOR**

(30) Priority: 24.09.2024 KR 20240129185
(71) Applicant: LG Energy Solution, Ltd., Seoul 07335 (KR)
(72) Inventor: KIM, Ki Hoon, Daejeon 34122 (KR); JEON, Mi Yeon, Daejeon 34122 (KR)
(74) Representative: Goddar, Heinz J.
(86) International application number: PCT/KR2025/014144
(87) International publication number: WO 2026/071575

(57) **Abstract**

This document relates to a battery diagnosis device including an interface configured to acquire present electric current information and present battery temperature information corresponding to a battery unit and a processor configured to compare previous battery temperature information and the present battery temperature information that correspond to the battery unit when the present electric current information is less than a threshold value, and diagnose an abnormality in the battery unit based on the comparison result.

## Description

### TECHNICAL FIELD

### Cross-reference to Related Applications

This application claims priority from Korean Patent Application No. 10-2024-0129185, filed on September 24, 2024, the disclosure of which is incorporated by reference herein.

### Technical Field

Embodiments disclosed in this document relate to a battery diagnosis device and battery diagnosis method.

### BACKGROUND ART

In recent years, secondary battery technology has made rapid progress and plays a crucial role in various industrial sectors. Secondary batteries are batteries that can be charged and discharged, and can be interpreted as including not only conventional nickel-cadmium batteries, nickel-metal hydride batteries, and lead-acid batteries, but also lithium-ion batteries. In particular, lithium-ion batteries play an essential role in electric vehicles (EVs), energy storage systems (ESS), and portable electronic devices.

The temperature of the battery is an important factor affecting performance and safety maintenance. Batteries store and release energy through chemical reactions, and temperature fluctuations can occur during this process. Temperature changes inside a battery directly affect its operating characteristics, and if the temperature is not properly maintained, battery performance may be degraded or serious safety issues may be caused.

In general, batteries perform optimally in a certain temperature range. However, if the battery temperature is out of this temperature range, the internal resistance increases and efficiency decreases. For example, at low temperatures, the chemical reactions in a battery slow down, which reduces discharge rate and as a result, its capacity may be limited. In contrast, at high temperatures, the chemical reactions in a battery can accelerate too quickly, which may shorten the life of the battery and degrade its output performance.

Furthermore, battery overheating can cause safety issues. When the battery overheats, gas may be generated inside the battery, which in severe cases may cause an explosion. Therefore, in order to optimize performance of the battery and ensure safety, it is necessary to continuously monitor the temperature of the battery to diagnose abnormal behavior of the battery in advance.

### DISCLOSURE OF THE INVENTION

### TECHNICAL PROBLEM

Embodiments provide a battery diagnosis device and battery diagnosis method capable of diagnosing an abnormality in a battery unit by monitoring the temperature of the battery unit.

Embodiments provide a battery diagnosis device and battery diagnosis method capable of diagnosing an abnormality in a battery unit based on electric current information of the battery unit, battery temperature information, and external temperature information.

Embodiments provide a battery diagnosis device and battery diagnosis method capable of diagnosing an abnormality in a battery unit based on a comparison of current battery temperature information and previous battery temperature information of the battery unit.

The technical problems of the present invention are not limited to the technical problems mentioned above, and other technical problems that are not mentioned may be clearly understood by those skilled in the art from the descriptions below.

### TECHNICAL SOLUTION

A battery diagnosis device according to an embodiment of this document includes an interface configured to acquire present electric current information and present battery temperature information corresponding to a battery unit and a processor configured to compare previous battery temperature information and the present battery temperature information that correspond to the battery unit when the present electric current information is less than a threshold value, and diagnose an abnormality in the battery unit based on the comparison result.

In an embodiment, the processor may be configured to increase a diagnostic count when the previous battery temperature information is less than the present battery temperature information and diagnose an abnormality in the battery unit based on the diagnostic count.

In an embodiment, the processor may be configured to diagnose the battery unit as an abnormal battery unit when the diagnostic count is greater than or equal to a threshold count.

In an embodiment, the processor may be configured to store the present battery temperature information as the previous battery temperature information when the diagnostic count is less than a threshold count.

In an embodiment, the interface may be configured to additionally acquire present external temperature information and the processor may be configured to increase a diagnostic count when the present external temperature information is less than the present battery temperature information and the previous battery temperature information is less than the present battery temperature information and diagnose an abnormality in the battery unit based on the diagnostic count.

In an embodiment, the processor may be configured to store the present battery temperature information as the previous battery temperature information when the present external temperature information is less than the present battery temperature information.

In an embodiment, the processor may be configured to generate notification information when an abnormality in the battery unit is diagnosed.

In an embodiment, the interface may be configured to acquire the present battery temperature information after a specific amount of time from a point in time when the previous battery temperature information corresponding to the battery unit is stored.

A battery diagnosis method according to an embodiment of this document includes acquiring present electric current information and present battery temperature information corresponding to a battery unit, comparing previous battery temperature information and the present battery temperature information that correspond to the battery unit when the present electric current information is less than a threshold value, and diagnosing an abnormality in the battery unit based on the comparison result.

In an embodiment, the diagnosing of the abnormality in the battery unit may include increasing a diagnostic count when the previous battery temperature information is less than the present battery temperature information, and diagnosing an abnormality in the battery unit based on the diagnostic count.

In an embodiment, the diagnosing of the abnormality in the battery unit may include diagnosing the battery unit as an abnormal battery unit when the diagnostic count is greater than or equal to a threshold count.

In an embodiment, the battery diagnosis method may further include storing the present battery temperature information as the previous battery temperature information when the diagnostic count is less than the threshold count.

In an embodiment, the battery diagnosis method may further include additionally acquiring present external temperature information, and the diagnosing of the abnormality in the battery unit may include increasing a diagnostic count when the present external temperature information is less than the current battery temperature information and the previous battery temperature information is less than the present battery temperature information, and diagnosing an abnormality in the battery unit based on the diagnostic count.

In an embodiment, the battery diagnosis method may further include storing the present battery temperature information as the previous battery temperature information when the present external temperature information is less than the present battery temperature information.

In an embodiment, the battery diagnosis method may further include generating notification information when an abnormality in the battery unit is diagnosed.

In an embodiment, the present battery temperature information may be acquired after a specific amount of time from a point in time when the previous battery temperature information corresponding to the battery unit is stored.

### ADVANTAGEOUS EFFECTS

The present technology can diagnose an abnormality in a battery unit by monitoring the temperature of the battery unit.

In addition, the present technology can diagnose the abnormality in the battery unit based on electric current information and temperature information of the battery unit.

In addition, the present technology can diagnose the abnormality in the battery unit based on the comparison of current battery temperature information and previous battery temperature information of the battery unit.

In addition, various effects that are directly or indirectly identified through this document can be provided.

### BRIEF DESCRIPTION OF THE DRAWINGS

FIG. 1 is a block diagram illustrating a battery pack, in a battery diagnosis device and battery diagnosis method according to an embodiment of this document.
FIG. 2 is a block diagram illustrating a configuration of a battery diagnosis device according to an embodiment of this document.
FIG. 3 is a diagram illustrating an example of present battery temperature information according to an embodiment of this document.
FIG. 4 is a flowchart for describing a battery diagnosis method according to an embodiment of this document.
FIG. 5 is a flowchart for describing a battery diagnosis method according to an embodiment of this document.
FIG. 6 is a block diagram illustrating a hardware configuration of a computing system that performs a battery diagnosis method according to an embodiment of this document.

### MODE FOR CARRYING OUT THE INVENTION

Hereinafter, with reference to the accompanying drawings, this document will be described in detail so that a person with ordinary knowledge in the technical field to which this document pertains can easily implement it. However, it should be understood that the present technology may be implemented in many different forms and includes various modifications, equivalents, and/or alternatives of embodiments of the present technology.

In order to clearly describe this document, parts unrelated to the description are omitted, and the same reference numerals are attached to the same or similar components throughout the specification.

In addition, terms or words used in this specification and claims should not be interpreted as limited to ordinary or dictionary meanings, but should be interpreted as meanings and concepts that conform to the technical idea of this document based on the principle that the inventor can appropriately define the concept of the term to describe his or her own invention in the best way.

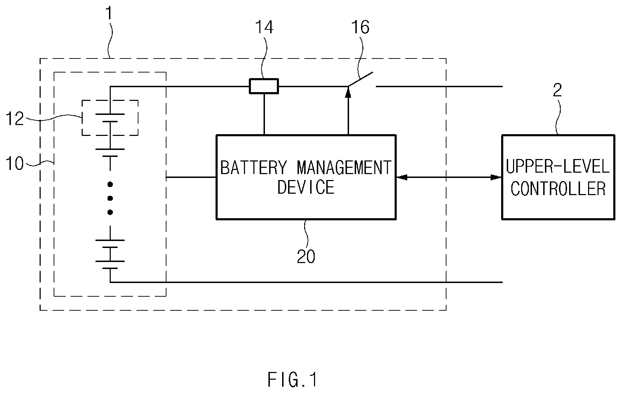

Hereinafter, embodiments of this document will be described in detail with reference to FIGS. 1 to 5.

FIG. 1 is a block diagram illustrating a battery pack, in a battery diagnosis device and battery diagnosis method according to an embodiment of this document.

Referring to FIG. 1, a battery pack 1 may include a battery unit 10, a sensor unit 14, a switching unit 16, and a battery management device 20. In this case, the battery pack 1 may be equipped with a plurality of battery units 10, sensor units 14, switching units 16, and battery management devices 20.

According to an embodiment, the battery unit 10 may supply power to a target device (not shown). To this end, the battery unit 10 may be electrically connected to the target device. Here, the target device may include an electrical, electronic, or mechanical device that operates by receiving power from the battery pack 1. For example, the target device may be, but is not limited to, an electric vehicle (EV).

According to an embodiment, the battery unit 10 may include at least one battery cell 12 that is chargeable and dischargeable. Here, the battery cell 12 may be a basic unit of a battery cell that can be used by charging and discharging electric energy. For example, the battery cell 12 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 10 may be connected in series or in parallel. For example, the battery unit 10 may be a battery module, a battery bank, or a set of battery cells (cell-to-pack structure).

According to an embodiment, the sensor unit 14 may acquire information related to the battery unit 10. According to an embodiment, the sensor unit 14 may acquire values (or information) related to a state of each of the battery units 10 or battery cells 12. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 10 to the battery management system 20.

According to an embodiment, the switching unit 16 may include a device for controlling a current flow for charging or discharging the battery unit 10. For example, the switching unit 16 may include at least one relay and/or magnetic contactor, etc., depending on the specifications of the battery pack 1.

According to an embodiment, the battery management device 20 may control or manage the battery pack 1 to prevent overcharging and overdischarging, etc. by monitoring the voltage, current, temperature, etc. of the battery pack 1. For example, the battery management device 20 is an interface that receives values acquired by measuring various parameters described above, and may include a plurality of terminals, a circuit connected to these terminals to process the received values, etc. In addition, the battery management device 20 may control the sensor unit 14 and/or the switching unit 16. For example, the battery management device 20 may be connected to a plurality of battery units 10 to monitor the state of each of the plurality of battery units 10 and control ON/OFF of a relay or contactor, etc.

According to an embodiment, an operation of the battery management device 20 may be performed by a battery management system (BMS) in a vehicle, and may also be performed in various devices such as a server, a cloud, a charger, or a charger/discharger.

An upper-level controller 2 may transmit a control signal for the plurality of battery units 10 to the battery management device 20. Accordingly, the operation of the battery management device 20 may be controlled based on a signal applied from the upper-level controller 2.

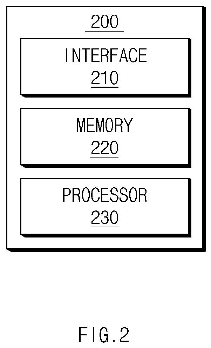

According to an embodiment, the battery management device 20 may include a battery diagnosis device 200 of FIG. 2. According to another embodiment, the battery management device 20 may be a different system from the battery diagnosis device 200 of FIG. 2. That is, the battery diagnosis device 200 of FIG. 2 may be included in the battery pack 1 or may be configured as another device external to the battery pack 1. Hereinafter, for convenience of description, the description will be made on the assumption that the battery diagnosis device 200 is configured as another device external to the battery pack 1. In addition, the operation of the battery diagnosis device 200 described below may be performed by the battery management system (BMS) in the vehicle, and may also be performed by various devices such as a server, a cloud, a charger, or a discharger.

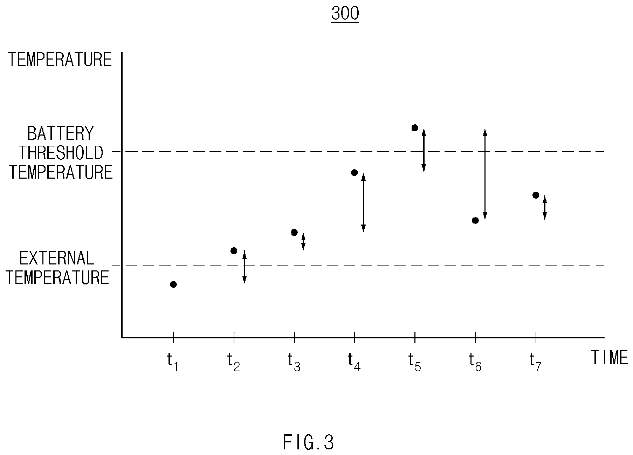

FIG. 2 is a block diagram illustrating a configuration of a battery diagnosis device according to an embodiment of this document. FIG. 3 is a diagram illustrating an example of current battery temperature information according to an embodiment of this document.

First, referring to FIG. 2, the battery diagnosis device 200 according to an embodiment of this document may include an interface 210, a memory 220, and a processor 230.

According to an embodiment, the interface 210 may acquire data corresponding to the battery unit 10 (see FIG. 1). Specifically, the interface 210 may acquire at least one of electric current data, voltage data, resistance data, and temperature data of the battery unit 10.

According to an embodiment, the interface 210 may acquire present electric current information and present battery temperature information corresponding to the battery unit 10. Specifically, the interface 210 may acquire present electric current information and present battery temperature information by receiving a electric current value and temperature value of the battery unit 10 at the present point in time from the sensor unit 14 (see FIG. 1). In addition, the interface 10 may include a sensor unit configured to acquire the present electric current information and/or the present battery temperature information of the battery unit 10. The sensor unit may include measuring means such as an ammeter or a thermometer for measuring the present electric current information and/or the present battery temperature information of the battery unit 10.

According to an embodiment, the interface 210 may acquire the present battery temperature information after a specific amount of time from the point in time when previous battery temperature information corresponding to the battery unit 10 was stored. Specifically, the interface 210 may acquire the present battery temperature information based on a certain time interval, i.e., a storage cycle, from the point in time when the previous battery temperature information is stored. In addition, the interface 210 may acquire present electric current information and present external temperature information based on the storage cycle. For example, when the storage cycle is 30 minutes, the interface 210 may newly acquire present battery temperature information, which is a value obtained by measuring the battery temperature at the present point in time, after 30 minutes have passed from the point in time when the present battery temperature information was acquired and stored as the previous battery temperature information.

According to an embodiment, the interface 210 may acquire the present external temperature information. Specifically, the interface 210 may communicate with an external device configured to measure the external temperature and acquire the present external temperature information obtained by measuring an external temperature value at the present point in time. For example, external devices may include the vehicle's climate control system, the body control module (BCM), etc. In addition, the interface 210 may acquire the present external temperature information from the external device through communication such as controller area network (CAN), local interconnect network (LIN), inter-integrated circuit (I2C), and serial peripheral interface (SPI).

According to an embodiment, the memory 220 may store at least one instruction. Specifically, the memory 220 may store at least one instruction for performing a battery diagnosis method according to an embodiment of this document. In addition, the memory 220 may temporarily and/or permanently store data acquired by the interface 210, data input to the processor 230, and/or operation results of the processor 230.

According to various embodiments, the memory 220 may include a volatile memory and/or a non-volatile memory. For example, the volatile memory may include at least one of static RAM (SRAM), dynamic RAM (DRAM), synchronous DRAM (SDRAM), and double date rate SDRAM (DDR SDRAM). In addition, the nonvolatile memory may include at least one of ROM, programmable ROM (PROM), erasable programmable ROM (EPROM), electrically erasable programmable ROM (EEPROM), flash memory, magnetic disk, and optical disk.

According to an embodiment, the processor 230 may execute at least one instruction stored in the memory 220. For example, the processor 230 may include at least one of a central processing unit (CPU), a microcontroller unit (MCU), a digital signal processor (DSP), a field-programmable gate array (FPGA), and an application-specific integrated circuit (ASIC). In addition, the processor 230 may be configured in one or more numbers. For example, the processor 230 may be configured as any one of a single core processor, a multi-core processor, and a multi-processor system.

According to an embodiment, the processor 230 may compare previous battery temperature information and present battery temperature information corresponding to the battery unit 10 when the present electric current information is less than a threshold value. Specifically, the processor 230 may compare the previous battery temperature information and present battery temperature information corresponding to the battery unit 10 when no electric current flows to the battery unit 10, such as during a rest period after charging or discharging the battery. For example, assuming that the threshold value is 1 A, the processor 230 may compare the previous battery temperature information and the present battery temperature information corresponding to the battery unit 10 when the present electric current information is less than 1 A, and identify whether the previous battery temperature information is less than the present battery temperature information. Accordingly, the processor 230 may diagnose an abnormality in the battery unit 10 by identifying a case where the temperature rises even though no electric current flows to the battery unit 10.

According to an embodiment, the processor 230 may store the present battery temperature information as the previous battery temperature information when the present external temperature information is less than the present battery temperature information. Specifically, the processor 230 may store the present battery temperature information as the previous battery temperature information when the present electric current information is less than a threshold value and the present external temperature information is less than the present battery temperature information.

For example, the processor 230 may store the present battery temperature information as the previous battery temperature information to diagnose abnormal battery behavior when no electric current flows to the battery unit 10 and the battery temperature is higher than the present external temperature. That is, the processor 230 may store the present battery temperature information as the previous battery temperature information in order to identify a situation in which the battery temperature continues to rise even though no electric current flows to the battery unit 10 and the battery temperature should gradually decrease to the present external temperature. Accordingly, the interface 210 may acquire the present battery temperature information at a point in time when a specific amount of time has elapsed from the point in time when the previous battery temperature information was stored, and the processor 230 may compare the newly acquired present battery temperature information and the previous battery temperature information.

According to an embodiment, the processor 230 may diagnose an abnormality in the battery unit 10 based on the comparison result. Specifically, the processor 230 may increase a diagnostic count when the previous battery temperature information is less than the present battery temperature information, and diagnose an abnormality in the battery unit based on the diagnostic count.

According to an embodiment, the processor 230 may diagnose the battery unit 10 as an abnormal battery unit when the diagnostic count is greater than or equal to a threshold count. Specifically, the threshold count may be set as a criterion for the total cumulative number of diagnostic counts or as a criterion for the number of consecutive increases in the diagnostic count.

For example, assuming that the threshold count is three times based on the total cumulative number, the processor 230 may diagnose the corresponding battery unit 10 as an abnormal battery unit when the diagnostic count has been increased three or more times cumulatively. In another example, assuming that the threshold count is three times based on the number of consecutive increases, the processor 230 may diagnose the battery unit 10 as an abnormal battery unit when the diagnostic count increases three or more consecutive times.

According to an embodiment, the processor 230 may store the present battery temperature information as the previous battery temperature information when the diagnostic count is less than the threshold count. Specifically, the processor 230 may increase the diagnostic count when the previous battery temperature information is less than the present battery temperature information, and may store the present battery temperature information as the previous battery temperature information when the increased diagnostic count is less than the threshold count. Accordingly, the interface 210 may acquire the present battery temperature information at a point in time when a specific amount of time has elapsed from the point in time when the previous battery temperature information was stored, and the processor 230 may compare the newly acquired present battery temperature information with the previous battery temperature information.

According to an embodiment, the processor 230 may increase the diagnostic count when the present external temperature information is less than the present battery temperature information and the previous battery temperature information is less than the present battery temperature information, and may diagnose an abnormality in the battery unit 10 based on the diagnostic count. Specifically, the processor 230 may compare the previous battery temperature information with the present battery temperature information when the present electric current information is less than the threshold value and the present external temperature information is less than the present battery temperature information, and diagnose an abnormality in the battery unit 10 based on the comparison result. For example, the processor 230 may increase the diagnostic count when the present electric current information is less than the threshold value and the present external temperature information is less than the present battery temperature information, and diagnose the corresponding battery unit 10 as an abnormal battery unit when the diagnostic count is greater than or equal to the threshold count.

According to an embodiment, the processor 230 may generate notification information when an abnormality in the battery unit 10 is diagnosed. Specifically, the notification information may include at least one of the degree of temperature rise of the battery unit 10, the temperature change during the last three storage cycles of the battery unit 10, and a message guiding an abnormality of the battery unit 10.

Hereinafter, the operation of the processor 230 will be described in more detail with reference to FIG. 3.

Referring to FIG. 3, the processor 230 may compare present battery temperature information acquired at regular time intervals with previous battery temperature information.

According to an embodiment, the interface 210 may acquire the present battery temperature information at regular time intervals, and the processor 230 may increase the diagnostic count when the previous battery temperature information is less than the present battery temperature information by comparing the previous battery temperature information acquired and stored in the previous cycle with the present battery temperature information. That is, since the processor 230 increases the diagnostic count when the battery temperature rises higher than the previous battery temperature information, the diagnostic count can be increased at each of points in time t2, t3, t4, t5, and t7.

In general, in the case of technologies that diagnose the state of a battery based on the temperature of the battery, the state of the battery is diagnosed as abnormal when the present battery temperature is greater than or equal to a specific value, and thus the state of the battery unit 10 may be diagnosed for the first time at the point in time t5 when the present battery temperature information is greater than or equal to the battery threshold temperature. On the other hand, according to an embodiment of this document, since the processor 230 may continuously monitor the temperature of the battery unit 10 to increase the diagnostic count even when the present battery temperature information is less than or equal to the battery threshold temperature, there is an effect that the state of the battery unit 10 may be diagnosed in advance.

In addition, in the case of general technologies that diagnose the state of the battery based on the temperature of the battery, the state of the battery is diagnosed as abnormal when a difference between the present battery temperature and the battery temperature obtained immediately before exceeds the threshold value, and thus the state of the battery unit 10 may be diagnosed at the points in time t4 and t5 when the difference value between the present battery temperature information and the previous battery temperature information exceeds the threshold value.

On the other hand, according to an embodiment of this document, since the processor 230 may increase the diagnostic count if the present battery temperature information is greater than or equal to the previous battery temperature information even when the difference value between the present battery temperature information and the previous battery temperature information does not exceed the threshold value, there is an effect that the state of the battery unit 10 may be diagnosed in advance.

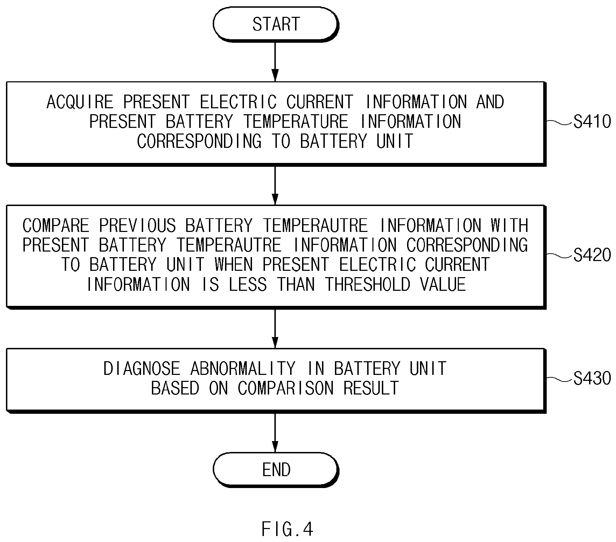

FIG. 4 is a flowchart for describing a battery diagnosis method according to an embodiment of this document. Hereinafter, it is assumed that the battery diagnosis device 200 of FIG. 2 performs each step of FIG. 4. Each step in FIG. 4 may be performed sequentially, but they are not necessarily performed sequentially. For example, the order of the steps may be changed, and a plurality of steps may be performed in parallel.

Referring to FIG. 4, in step S410, the battery diagnosis device 200 may acquire present electric current information and present battery temperature information corresponding to the battery unit 10. Specifically, the battery diagnosis device 200 may acquire the present electric current information, which is a value obtained by measuring the electric current of the battery unit 10 at the present point in time, and the present battery temperature information, which is a value obtained by measuring the temperature at the present point in time. For example, the battery diagnosis device 200 may acquire the present electric current information and the present battery temperature information through the interface 210. As another example, the battery diagnosis device 200 may acquire the present electric current information and the present battery temperature information through the sensor unit 14.

For example, the battery diagnosis device 200 may additionally acquire present external temperature information. Specifically, the battery diagnosis device 200 may be electrically connected to an external device and may acquire the present external temperature information, which is a value obtained by measuring the external temperature at the present point in time, from the external device.

In step S420, the battery diagnosis device 200 may compare the previous battery temperature information with the present battery temperature information corresponding to the battery unit 10 when the present electric current information is less than the threshold value. Specifically, the battery diagnosis device 200 may quantitatively compare the present battery temperature information with the previous battery temperature information to identify whether the previous battery temperature information is less than the present battery temperature information.

In step S430, the battery diagnosis device 200 may diagnose an abnormality in the battery unit 10 based on the comparison result. Specifically, the battery diagnosis device 200 may increase a diagnostic count when the previous battery temperature information is less than the present battery temperature information, and diagnose an abnormality in the battery unit 10 based on the diagnostic count.

For example, the battery diagnosis device 200 may diagnose the battery unit 10 as an abnormal battery unit when the diagnostic count is greater than or equal to a threshold count. In addition, the battery diagnosis device 200 may store the present battery temperature information as the previous battery temperature information when the diagnostic count is less than the threshold count.

For example, the battery diagnosis device 200 may increase the diagnostic count when the present external temperature information is less than the present battery temperature information and the previous battery temperature information is less than the present battery temperature information. In addition, the battery diagnosis device 200 may diagnose an abnormality in the battery unit based on the diagnostic count.

For example, the battery diagnosis device 200 may store the present battery temperature information as the previous battery temperature information when the present external temperature information is less than the present battery temperature information. That is, the battery diagnosis device 200 may diagnose an abnormality in the battery unit 10 by comparing the present battery temperature information acquired after a storage cycle has elapsed with the present battery temperature information obtained by storing the present battery temperature information as the previous battery temperature information when the present battery temperature information is greater than or equal to the present external temperature information.

For example, the battery diagnosis device 200 may generate notification information when an abnormality in the battery unit 10 is diagnosed. Specifically, the notification information may include at least one of the degree of temperature rise of the battery unit 10, the temperature change during the last three storage cycles of the battery unit 10, and a message guiding an abnormality of the battery unit 10.

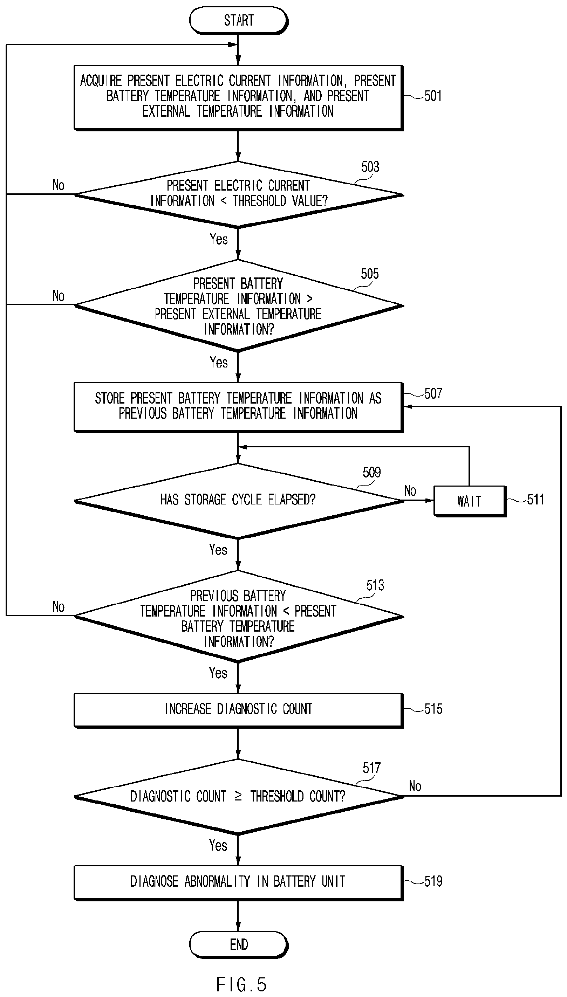

FIG. 5 is a flowchart for describing a battery diagnosis method according to an embodiment of this document.

Hereinafter, it is assumed that the battery diagnosis device 200 of FIG. 2 performs each operation of FIG. 5. In addition, in the description of FIG. 5, it may be understood that the operations described as being performed by the battery diagnosis device 200 are controlled by the processor 230 included in the battery diagnosis device 200.

Referring to FIG. 5, in operation 501, the processor 230 of battery diagnosis device 200 may acquire present electric current information, present battery temperature information, and present external temperature information. According to an embodiment, the present electric current information, the present battery temperature information, and the present external temperature information may be acquired by the interface 210. In addition, the present electric current information, the present battery temperature information, and the present external temperature information may be acquired at regular time intervals (hereinafter, storage cycles).

In operation 503, the processor 230 may identify whether the present electric current information is less than a threshold value. For example, when the present electric current information is greater than or equal to the threshold value, the processor 230 may perform operation 501 after the storage cycle has elapsed. In addition, when the present electric current information is less than the threshold value, the processor 230 may perform operation 505.

In operation 505, the processor 230 may identify whether the present external temperature information is less than the present battery temperature information. For example, when the present external temperature information is greater than or equal to the present battery temperature information, the processor 230 may perform operation 501 after the storage cycle has elapsed. In addition, when the present external temperature information is less than the present battery temperature information, the processor 230 may perform operation 507.

In operation 507, the processor 230 may store the present battery temperature information as previous battery temperature information. The processor 230 may perform operation 509 after storing the present battery temperature information as the previous battery temperature information.

In operation 509, the processor 230 may identify whether the storage cycle has elapsed. For example, when a storage cycle has elapsed since the present battery temperature information was stored as the previous battery temperature information, the processor 230 may perform operation 513 after acquiring the present battery temperature information again. In addition, when the storage cycle has not elapsed since the present battery temperature information was stored as the previous battery temperature information, the processor 230 may perform operation 511.

In operation 511, the processor 230 may wait until the storage cycle elapses when the storage cycle has not elapsed. For example, when the storage cycle has not elapsed, the processor 230 may not perform the operation of acquiring the present battery temperature information and the operation of comparing the previous battery temperature information with the present battery temperature information. The processor 230 may perform operation 513 after waiting until the storage cycle has elapsed.

In operation 513, the processor 230 may identify whether the previous battery temperature information is less than the present battery temperature information. For example, when the previous battery temperature information is greater than or equal to the present battery temperature information, the processor 230 may store the present battery temperature information as the previous battery temperature information and perform operation 501 after the storage cycle has elapsed. In addition, when the previous battery temperature information is less than the present battery temperature information, the processor 230 may perform operation 515.

In operation 515, the processor 230 may increase the diagnostic count when the previous battery temperature information is less than the present battery temperature information. When the processor 230 increases the diagnostic count, the processor 230 may perform operation 517.

In operation 517, the processor 230 may identify whether the diagnostic count is greater than or equal to a threshold count. For example, when the diagnostic count is less than the threshold count, the processor 230 may perform operation 507. In addition, when the diagnostic count is greater than or equal to the threshold count, the processor 230 may perform operation 519.

In operation 519, the processor 230 may diagnose an abnormality in the battery unit when the diagnostic count is greater than or equal to the threshold count. For example, the processor 230 may diagnose the battery unit as an abnormal battery unit when the diagnostic count is greater than or equal to the threshold count.

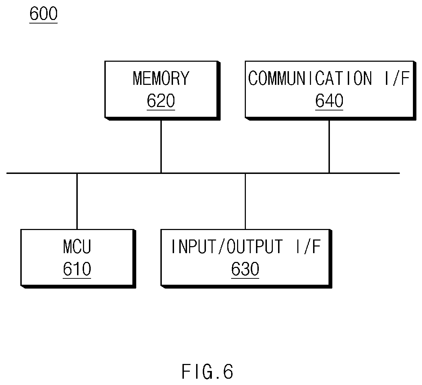

FIG. 6 is a block diagram illustrating a hardware configuration of a computing system that performs a battery diagnosis method according to an embodiment of this document.

Referring to FIG. 6, a computing system 600 according to an embodiment disclosed in this document may include an MCU 610, a memory 620, an input/output I/F 630, and a communication I/F 640.

The MCU 610 may be a processor that executes various programs (e.g., battery cell data collection program, graph generation program, data analysis program, data decomposition algorithm, normalization program, and battery cell diagnosis program, etc.) stored in the memory 620, processes various information including characteristic data of the battery cell, latent variables, etc. through these programs, and performs the functions of the battery diagnosis device 200 shown in FIGS. 1 to 5 described above.

The memory 620 may store various programs such as the battery cell data collection program, the graph generation program, the data analysis program, the data decomposition algorithm, the normalization program, and the battery cell diagnosis program.

A plurality of such memories 620 may be provided as needed. The memory 620 may be a volatile memory or a nonvolatile memory. The memory 620 used as the volatile memory may be RAM, DRAM, SRAM, etc. The memory 620 used as the nonvolatile memory may be ROM, PROM, EAROM, EPROM, EEPROM, flash memory, etc. The examples of the memories 620 listed above are only examples, but are not limited to these examples.

The input/output I/F 630 may provide an interface that allows data to be transmitted and received by connecting an input device (not shown) such as a keyboard, mouse, or touch panel and an output device such as a display (not shown) with the MCU 610.

The communication I/F 640 is a configuration that can transmit and receive various data with the server, and may be various devices that can support wired or wireless communication. For example, the battery diagnosis device 200 may transmit and receive various information including shape models of battery cells, etc. to and from a separately provided external server through the communication I/F 640.

In this way, the computer program according to an embodiment disclosed in this document may be implemented as a module that performs, for example, each function shown in FIG. 2, by being recorded in the memory 620 and processed by the MCU 610.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

Although the document has been described above with limited embodiments and drawings, this document is not limited thereto, and various implementations are possible within the technical idea of this document and the scope equivalent to the claims described below by a person having ordinary knowledge in the technical field to which this document pertains.

## Claims

1. A battery diagnosis device, comprising:
an interface configured to acquire present electric current information and present battery temperature information corresponding to a battery unit; and
a processor configured to compare previous battery temperature information and the present battery temperature information that correspond to the battery unit when the present electric current information is less than a threshold value, and diagnose an abnormality in the battery unit based on the comparison result.

2. The battery diagnosis device of claim 1, wherein the processor is configured to increase a diagnostic count when the previous battery temperature information is less than the present battery temperature information and diagnose an abnormality in the battery unit based on the diagnostic count.

3. The battery diagnosis device of claim 2, wherein the processor is configured to diagnose the battery unit as an abnormal battery unit when the diagnostic count is greater than or equal to a threshold count.

4. The battery diagnosis device of claim 2, wherein the processor is configured to store the present battery temperature information as the previous battery temperature information when the diagnostic count is less than a threshold count.

5. The battery diagnosis device of claim 1, wherein the interface is configured to additionally acquire present external temperature information, and
the processor is configured to increase a diagnostic count when the present external temperature information is less than the present battery temperature information and the previous battery temperature information is less than the present battery temperature information and diagnose an abnormality in the battery unit based on the diagnostic count.

6. The battery diagnosis device of claim 5, wherein the processor is configured to store the present battery temperature information as the previous battery temperature information when the present external temperature information is less than the present battery temperature information.

7. The battery diagnosis device of claim 1, wherein the processor is configured to generate notification information when an abnormality in the battery unit is diagnosed.

8. The battery diagnosis device of claim 1, wherein the interface is configured to acquire the present battery temperature information after a specific amount of time from a point in time when the previous battery temperature information corresponding to the battery unit is stored.

9. A battery diagnosis method comprising:
acquiring present electric current information and present battery temperature information corresponding to a battery unit;
comparing previous battery temperature information and the present battery temperature information that correspond to the battery unit when the present electric current information is less than a threshold value; and
diagnosing an abnormality in the battery unit based on the comparison result.

10. The battery diagnosis method of claim 9, wherein, in the diagnosing of the abnormality in the battery unit, a diagnostic count is increased when the previous battery temperature information is less than the present battery temperature information and an abnormality in the battery unit may be diagnosed based on the diagnostic count.

11. The battery diagnosis method of claim 10, wherein, in the diagnosing of the abnormality in the battery unit, the battery unit is diagnosed as an abnormal battery unit when the diagnostic count is greater than or equal to a threshold count.

12. The battery diagnosis method of claim 10, further comprising:
storing the present battery temperature information as the previous battery temperature information when the diagnostic count is less than the threshold count.

13. The battery diagnosis method of claim 9, further comprising:
additionally acquiring present external temperature information,
wherein diagnosing of the abnormality in the battery unit comprises:
increasing a diagnostic count when the present external temperature information is less than the present battery temperature information and the previous battery temperature information is less than the present battery temperature information and
diagnosing an abnormality in the battery unit based on the diagnostic count.

14. The battery diagnosis method of claim 13, further comprising:
storing the present battery temperature information as the previous battery temperature information when the present external temperature information is less than the present battery temperature information.

15. The battery diagnosis method of claim 9, further comprising:
generating notification information when an abnormality in the battery unit is diagnosed.

16. The battery diagnosis method of claim 9, wherein the present battery temperature information is acquired after a specific amount of time from a point in time when the previous battery temperature information corresponding to the battery unit is stored.
